# EUROPEAN PATENT APPLICATION

(11) **EP 4 668 329 A1**
(43) Date of publication of application: **24.12.2025**
(21) Application number: 25172990.1
(22) Date of filing: 28.04.2025
(51) Int. Cl.: H01L 23/34, H01L 23/40, H01L 23/367

(54) **THERMAL CONTROL APPARATUS FOR AN ELECTRONIC COMPONENT**

(30) Priority: 21.06.2024 US 202418749854
(71) Applicant: The Boeing Company, Arlington, VA 22202 (US)
(72) Inventor: SUDHINDRA, Swadish, Arlington, 22202 (US); SRINIVASA MURTHY, Jayaram B., Arlington, 22202 (US); KURIAKOSE, Mathews Leslie, Arlington, 22202 (US)
(74) Representative: Boult Wade Tennant LLP

(57) **Abstract**

The present disclosure provides a thermal control apparatus. The thermal control apparatus includes an integrated circuit (IC) and a heater film arranged in thermal communication with the IC. The heater film is arranged to selectively heat the IC during relatively cold conditions, or rather, when a temperature associated with the IC reaches a threshold. The thermal control apparatus also includes a heatsink arranged in thermal communication with the IC for dissipating heat generated by the IC during relatively hot conditions.

## Description

### FIELD

Examples of the present disclosure relate to a thermal control apparatus for providing thermal control of an electronic component.

### BACKGROUND

Electronic components, such as Integrated Circuits (IC), utilized in aerospace applications can be subjected to harsh environments, with temperature environments ranging from -40°C to greater than +85°C. Many commercially available ICs are designed for operations ranging from 0°C to +70°C. Consequently, component selection for ICs subjected to temperatures below 0°C is somewhat limited, even in newer technologies/applications. Some ICs can be screened to function in such extended temperature environments, but this can increase the cost and can impact reliability of such ICs. Further, some existing solutions modify the environment around an IC, but such solutions can have limitations with space, power consumption, and IC package types. Accordingly, there is a need for an improved solution for thermally controlling electronic components in harsh conditions.

### SUMMARY

The present disclosure provides a thermal control apparatus in an example. The thermal control apparatus including: an integrated circuit (IC); a heater film arranged in thermal communication with the IC, the heater film being arranged to selectively heat the IC when a temperature associated with the IC reaches a threshold; and a heatsink arranged in thermal communication with the IC for dissipating heat generated by the IC.

In one example, in combination with any example thermal control apparatus above or below, the thermal control apparatus may further include a thermal pad disposed between the IC and the heater film, wherein the heater film is disposed directly on the thermal pad.

In some examples, in combination with any example thermal control apparatus above or below, the thermal control apparatus may further include a frame defining a cutout in which the heater film is disposed.

In some examples, in combination with any example thermal control apparatus above or below, the thermal control apparatus may further include a plurality of heat columns attached to the frame at their respective first ends and to a base of the heatsink at their respective second ends.

In some examples, in combination with any example thermal control apparatus above or below, at least a portion of the thermal pad may directly contact the frame.

In some examples, in combination with any example thermal control apparatus above or below, the thermal control apparatus may further include a printed circuit board (PCB), the IC being disposed on the PCB; and captive screws coupling the frame with the PCB.

In some examples, in combination with any example thermal control apparatus above or below, the thermal control apparatus may further include a sensor arranged to sense the temperature associated with the IC; a power supply electrically coupled with the heater film; and one or more processors communicatively coupled with the sensor and the power supply, the one or more processors may be configured to: receive, from the sensor, inputs indicating the temperature associated with the IC; and when the temperature associated with the IC reaches the threshold, may cause the power supply to supply electric power to the heater film.

In some examples, in combination with any example thermal control apparatus above or below, the electric power supplied to the heater film may vary according to a heating profile based at least in part on the temperature associated with the IC.

In some examples, in combination with any example thermal control apparatus above or below, the heater film may be disposed directly on a base of the heatsink.

In some examples, in combination with any example thermal control apparatus above or below, the heatsink may have a plurality of pillars and the heater film defines a plurality of apertures through which the plurality of pillars extend.

In some examples, in combination with any example thermal control apparatus above or below, the base of the heatsink may have mounting posts through which respective captive screws extend through and couple the heatsink with a printed circuit board.

In some examples, in combination with any example thermal control apparatus above or below, the thermal control apparatus may further include a heatsink thermal pad arranged on the heatsink; and a top plate disposed on the heatsink thermal pad, the top plate being in thermal communication with a remote heatsink.

In some examples, in combination with any example thermal control apparatus above or below, the thermal control apparatus may further include a second IC; and a second thermal pad disposed on the second IC, wherein the heater film may be arranged in thermal communication with the second IC, the heater film may be arranged to selectively heat the IC and the second IC when a temperature associated with the IC, the second IC, or both reaches a threshold, and wherein the heatsink may be arranged in thermal communication with the second IC for dissipating heat generated by the second IC.

In some examples, in combination with any example thermal control apparatus above or below, the thermal control apparatus may further include a second IC; a second thermal pad disposed on the second IC; and a second heater film arranged in thermal communication with the second IC, the second heater film may be arranged to selectively heat the second IC when a temperature associated with the second IC reaches a threshold, and wherein the heatsink may be arranged in thermal communication with the second IC for dissipating heat generated by the second IC.

The present disclosure provides a thermal control apparatus in another example. The thermal control apparatus including: a printed circuit board (PCB); an integrated circuit (IC); a thermal pad disposed on the IC; a frame securing the IC and the thermal pad to the PCB, the frame defines a cutout and has a frame body and heat columns extending from the frame body; a heater film disposed on the IC and within the cutout, the heater film being arranged to selectively heat the IC when a temperature associated with the IC reaches a threshold; and a heatsink supported by the heat columns and arranged in thermal communication with the IC for dissipating heat generated by the IC.

In some examples, in combination with any example thermal control apparatus above or below, the thermal control apparatus may further include a sensor arranged to sense the temperature associated with the IC; a power supply electrically coupled with the heater film; and one or more processors communicatively coupled with the sensor and the power supply, the one or more processors may be configured to: receive, from the sensor, inputs indicating the temperature associated with the IC; and when the temperature associated with the IC reaches the threshold, may cause the power supply to supply electric power to the heater film.

In some examples, in combination with any example thermal control apparatus above or below, the one or more processors may be further configured to: when the temperature associated with the IC reaches a deactivation threshold temperature, cause the power supply to cease supplying electric power to the heater film.

The present disclosure provides a thermal control apparatus in another example. The thermal control apparatus including: an integrated circuit (IC); a heatsink arranged in thermal communication with the IC for dissipating heat generated by the IC and having a base and a plurality of pillars extending from the base; and a heater film disposed on the base and defining a plurality of apertures through which the plurality of pillars extend, the heater film being arranged to selectively heat the IC when a temperature associated with the IC reaches a threshold.

In some examples, in combination with any example thermal control apparatus above or below, the thermal control apparatus may further include a sensor arranged to sense the temperature associated with the IC; a power supply electrically coupled with the heater film; and one or more processors communicatively coupled with the sensor and the power supply, the one or more processors may be configured to: receive, from the sensor, inputs indicating the temperature associated with the IC; and when the temperature associated with the IC reaches the threshold, may cause the power supply to supply electric power to the heater film.

In some examples, in combination with any example thermal control apparatus above or below, the one or more processors may be further configured to: when the temperature associated with the IC reaches a deactivation threshold temperature, cause the power supply to cease supplying electric power to the heater film.

### BRIEF DESCRIPTION OF THE DRAWINGS

So that the manner in which the above recited features can be understood in detail, a more particular description, briefly summarized above, may be had by reference to example features, some of which are illustrated in the appended drawings.
FIG. 1A illustrates a perspective exploded view of a thermal control apparatus.
FIG. 1B illustrates a side view of the thermal control apparatus of FIG. 1A.
FIG. 1C illustrates a close-up view of Section C depicted in FIG. 1B.
FIG. 1D illustrates a close-up view of an alternative arrangement of Section C depicted in FIG. 1B.
FIG. 1E illustrates a system diagram of a heater control system of the thermal control apparatus of FIGS. 1A and 1B.
FIG. 2A illustrates a perspective exploded view of a thermal control apparatus.
FIG. 2B illustrates a side view of the thermal control apparatus of FIG. 2A.
FIG. 2C illustrates a system diagram of a heater control system of the thermal control apparatus of FIGS. 2A and 2B.
FIG. 3 illustrates a thermal control apparatus.
FIG. 4 illustrates a thermal control apparatus.

### DETAILED DESCRIPTION

The present disclosure relates to a thermal control apparatus for providing thermal control of an electronic component, such as an Integrated Circuit (IC), in extreme or harsh temperature environments, such as temperature environments ranging from -40°C to greater than +85°C. The thermal control apparatus disclosed herein can be particularly well suited for aerospace applications, such as for avionics of aircraft or spacecraft.

In some examples, a thermal control apparatus is disclosed. The thermal control apparatus can provide a dual-purpose thermal solution for heating or cooling an electronic component, such as an IC, depending on the conditions. The thermal control apparatus can include at least one IC, a heatsink, and an integrated thin film smart heater. The heatsink can be used to cool the IC in high temperature environments while the smart heater can be selectively activated to heat the IC in cold temperature environments. The smart heater can be used to heat the IC to a temperature above a minimum working temperature of the IC, for example. The heater can be controlled based on feedback from a sensor, and in some examples, based on a heating profile. In this way, the IC can meet qualification and performance requirements, such as qualification and performance requirements for aerospace applications.

The thermal control apparatus of the present disclosure can provide certain advantages, benefits, and/or technical effects. For instance, the thermal control apparatus of the present disclosure can enable the use of a Commercial Off-The-Shelf (COTS) IC for avionics applications, or more generally, aerospace applications. The thermal control provided by the thermal control apparatus can eliminate or reduce the need for a customized IC that is able to withstand harsh conditions. As COTS ICs can be utilized, the component selection of ICs for the aerospace domain can be expanded. Accordingly, technological advancements to ICs can be readily adapted to the aerospace domain, as well as other harsh condition domains. Further, the smart heater of the thermal control apparatus of the present disclosure can be controlled based on feedback from a temperature sensor and on a heating profile, which can be specific to the IC. This control scheme can result in savings of space and power consumption. Moreover, the smart heater can be integrated into the apparatus as a thin film and arranged in thermal communication with the IC to enable an IC to be heated within certain time limit requirements, such as start-up time limits for ICs of avionics. The thermal control apparatus of the present disclosure can have other advantages, benefits, and/or technical effects than those noted herein.

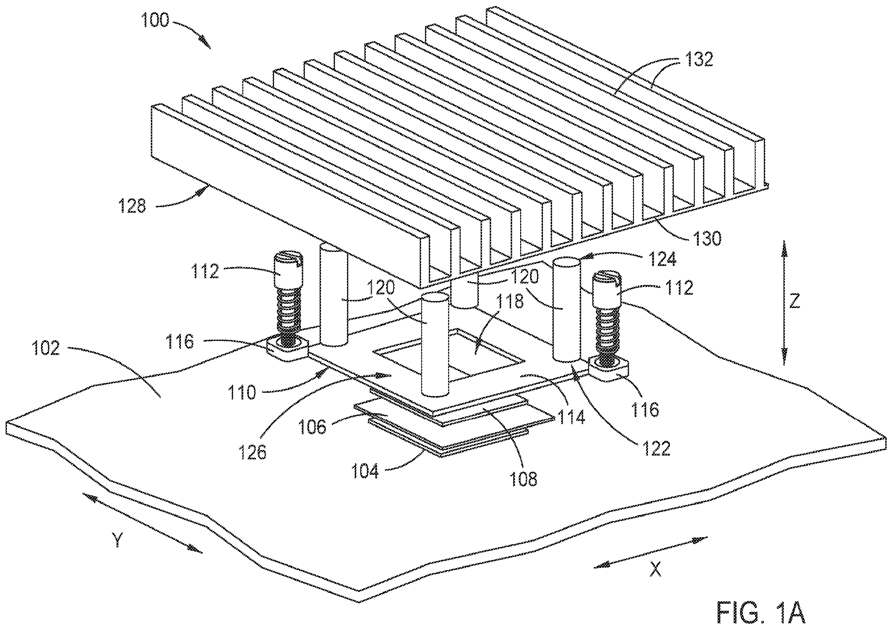

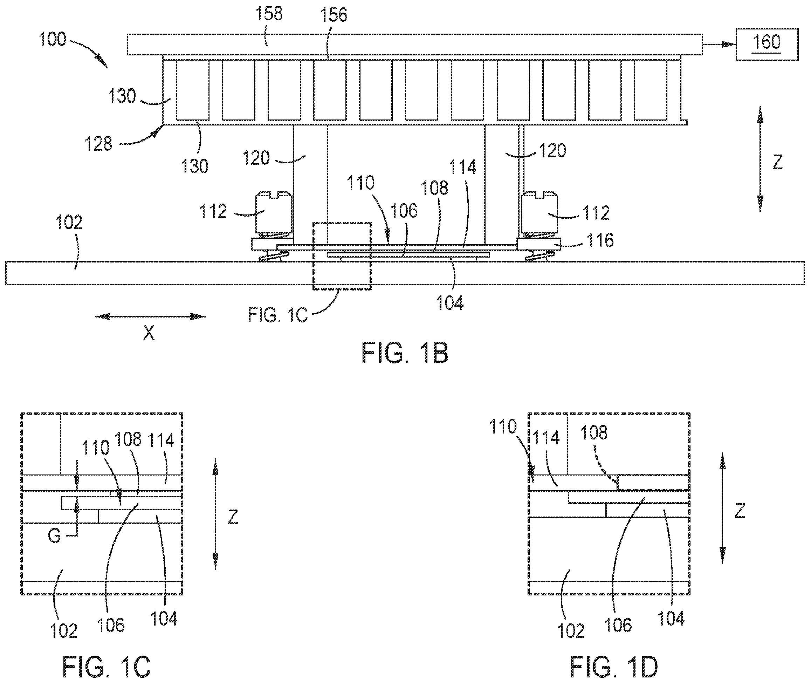

FIGS. 1A and 1B illustrate a thermal control apparatus 100. For reference, the thermal control apparatus 100 can define a first direction X, a second direction Y, and a third direction Z, which are mutually perpendicular to one another.

As depicted, the thermal control apparatus 100 can include a Printed Circuit Board (PCB), or PCB 102, and an electronic component disposed on the PCB 102. For instance, the electronic component can be an Integrated Circuit (IC), or IC 104. The IC 104 can be, for example, an Application Specific Integrated Circuit (ASIC), a Graphics Processing Unit (GPU), a Central Processing Unit (CPU), a Field-Programmable Gate Array (FPGA), a Digital Signal Processor (DSP), a memory device, etc. The thermal control apparatus 100 can also include a thermal pad 106 disposed on the IC 104. The thermal pad 106 can be formed of a Thermal Interface Material (TIM). In some examples, the thermal pad 106 can be disposed directly on the IC 104, e.g., as shown in FIGS. 1A and 1B. In at least some examples, an area of the thermal pad 106 is greater than or equal to an area of the IC 104. In this way, the thermal pad 106 can be arranged on the IC 104 so that the thermal pad 106 overhangs the IC 104, e.g., so that the thermal pad 106 overhangs each side of the IC 104.

The thermal control apparatus 100 can further include a thin film smart heater, or heater film 108. The heater film 108 can be arranged in thermal communication with the IC 104 so that the heater film 108 can heat the IC 104, e.g., in relatively cold conditions. In some examples, the heater film 108 can be disposed on the thermal pad 106, such as disposed directly on the thermal pad 106, e.g., as shown in FIG. 1B.

The thermal control apparatus 100 can further include a frame 110 to secure the IC 104, the thermal pad 106, and the heater film 108 to the PCB 102 by way of captive screws 112. The frame 110 can be formed of copper or another thermally conductive material, for example. The frame 110 can include a frame body 114 and mounting posts 116 projecting from corners of the frame body 114, such as from opposing corners as shown in FIG. 1A. The frame 110, or more specifically the frame body 114, can define a cutout 118. The cutout 118 is rectangular in shape in the example of FIGS. 1A and 1B but other shapes are possible. The heater film 108 can be arranged, at least in part, within the cutout 118, e.g., as shown in FIG. 1B. The cutout 118 can be defined to have an area that is complementary to an area of the heater film 108 (with the heater film 108 having a slightly smaller XY area so that the heater film 108 can be received within the cutout 118). In at least some examples, the area of the heater film 108 is less than the area of the thermal pad 106. In this regard, as shown in FIG. 1C, a gap G, which is unimpeded by the heater film 108, can be defined between a top surface of the thermal pad 106 and a bottom surface of the frame body 114. In some other examples, as shown in FIG. 1D, the stacked components can be arranged so that the bottom surface of the frame body 114 contacts a top surface of the thermal pad 106. This can create a direct thermally-conductive path between the thermal pad 106 and the frame 110, which may be beneficial for cooling the IC 104. In FIG. 1D, the heater film 108 (shown in phantom lines) can be disposed within the cutout 118 (FIG. 1A) so that a bottom surface thereof is flush or at a same vertical height with the bottom surface of the frame body 114.

With reference to FIGS. 1A and 1B, the thermal control apparatus 100 can also include conductive columns or heat columns 120. The heat columns 120 can be formed of copper or another thermally conductive material, for example. The heat columns 120 have respective lower ends 122 and respective upper ends 124. The respective lower ends 122 of the heat columns 120 can be attached to a top surface 126 of the frame 110 and the respective upper ends 124 of the heat columns 120 can be attached to a heatsink 128, which is supported by the heat columns 120. The heatsink 128 is arranged in thermal communication with the IC 104 for dissipating heat generated by the IC 104, e.g., during relatively hot conditions. The heatsink 128 can include a base 130 and a plurality of fins 132 extending from the base 130. The base 130 is arranged in an XY plane (and has a thickness along the third direction Z) that is spaced from an XY plane in which the frame body 114 is arranged (the frame body 114 also has a thickness along the third direction Z). Accordingly, the base 130 and the frame body 114 are oriented parallel to, and spaced from, one another. The respective upper ends 124 of the heat columns 120 can be attached to a bottom surface of the base 130. In at least some examples, the heat columns 120 can include a wick structure to transfer heat from the IC 104 to the heatsink 128. In at least some examples, the wick structure can be a screen mesh, a sintered metal powder layer, a grooved layer, or some combination of the foregoing.

In at least some examples, the heater film 108 can be a thin film polyamide heater and can include circuitry that can be selectively activated to heat the IC 104, e.g., in relatively cold conditions. The heater film 108 can be a Commercial Off-The-Shelf (COTS) smart heater or a custom heater implemented with one or more sensing elements as part of a heater control system. An example is provided below.

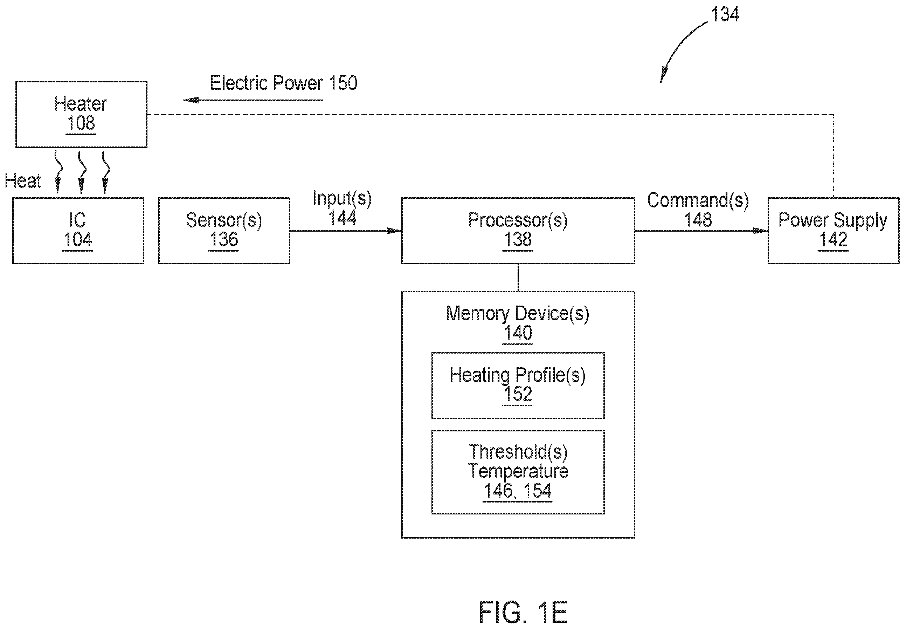

FIG. 1E depicts one example heater control system 134 for controlling the heater film 108, e.g., during relatively cold conditions. The heater control system 134 can include a sensor 136 (or a plurality of sensors), a processor 138 (or a plurality of processors), a memory device 140 (e.g., or a plurality of non-transitory memory devices), a power supply 142, and the heater film 108. In some examples, the processor 138 and the memory device 140 can be embodied in a computing device or controller. The computing device can have a communication interface for facilitating communication between the computing device and other devices, such as the sensor 136, the power supply 142, etc. The sensor 136 is communicatively coupled with the processor 138, e.g., by way of one or more wired or wireless communication links. The sensor 136 can be arranged to sense a temperature of the IC 104. The sensor 136 can be attached to, integrated into, or placed in proximity to the IC 104 so that the temperature of the IC 104 can be sensed. The processor 138 can receive inputs 144 from the sensor 136 indicating a temperature of the IC 104.

The processor 138 can receive the inputs 144, and based on the inputs 144, the processor 138 can determine the temperature of the IC 104. Based on the temperature of the IC 104, the heater film 108 can be selectively activated. For instance, during relatively cold conditions, such as during conditions in which the temperature of the IC 104 is at or below zero degrees Celsius (0°C), the processor 138 can control the power supply 142 electrically coupled with the heater film 108 to supply electric power to the heater film 108. In at least some examples, when the temperature associated with the IC 104 reaches an activation threshold temperature 146 (e.g., zero degrees Celsius (0°C)), the processor 138 can send a command 148 (or a plurality of commands) to the power supply 142. In this regard, the processor 138 is communicatively coupled with the power supply 142, e.g., by way of one or more wired or wireless communication links. Based on the command 148, controllable devices (e.g., switches) of the power supply 142 can be controlled so that electric power 150 can be directed to the heater film 108. The electric power 150 delivered to the heater film 108 can cause the heater film 108 to generate heat, e.g., by electric current passing through electric resistive elements (e.g., resistors) of the heater film 108. In this way, the heater film 108 can heat the IC 104 during relatively cold conditions.

In some examples, the heater film 108 can be heated according to a heating profile 152 based on the temperature at the IC 104. The memory device 140, which is communicatively coupled with the processor 138, can store the heating profile 152 (or a plurality of heating profiles). The processor 138 can access the heating profile 152, and based at least in part on the temperature associated with the IC 104, the processor 138 can control the power supply 142 so that the electric power 150 supplied to the heater film 108 is supplied according to the heating profile 152. In some instances, the electric power 150 supplied to the heater film 108 can be varied according to the heating profile 152. In some examples, the electric power 150 supplied to the heater film 108 can be supplied at a rated power until the temperature of the IC 104 is within a predetermined range of a deactivation threshold temperature 154, and when the temperature of the IC 104 is within the predetermined range of the deactivation threshold temperature 154, the electric power 150 supplied to the heater film 108 can be changed (e.g., ramped up or ramped down) based on the temperature of the IC 104 in accordance with the heating profile 152. Controlling the heat output of the heater film 108 according to the heating profile 152 can be beneficial, such as for power consumption purposes.

In at least some examples, when the temperature of the IC 104 reaches the deactivation threshold temperature 154, the heater film 108 can be selectively deactivated so that the IC 104 is no longer heated by the heater film 108. In some examples, the activation threshold temperature 146 can be the same as the deactivation threshold temperature 154. In some other examples, the activation threshold temperature 146 can be different than the deactivation threshold temperature 154. In some other examples, the heater film 108 can be selectively activated, and after a predefined heating time has elapsed, the heater film 108 can be selectively deactivated.

With reference to FIG. 1B, for relatively hot conditions, such as during conditions in which the temperature of the IC 104 is above zero degrees Celsius (0°C), heat can be transferred from the IC 104 to the heatsink 128 along a thermal path. Specifically, during operation, the IC 104 generates heat. The generated heat can be transferred to the thermal pad 106. The thermal pad 106 can transfer the heat to the frame 110, e.g., through the heater film 108 and/or directly to the frame 110. For instance, heat can travel from the thermal pad 106 to the frame 110 by of way of convection via the gap G (FIG. 1C) or both convectively and conductively when the thermal pad 106 is in contact with the frame 110 as in FIG. 1D. Heat can also travel from the thermal pad 106 to the heater film 108 (when deactivated), and then from the heater film 108 to the frame 110. The heat can travel through the frame body 114 of the frame 110 and to the heat columns 120. The heat can travel vertically upward through the heat columns, which can be facilitated by the wick structure therein, and can reach the base 130 of the heatsink 128. The heat can spread from the base 130 to the fins 132. Accordingly, heat can be transferred from the IC 104 to the heatsink 128. In some examples, an air mover or fan (not pictured) can be used to move air across the thermal control apparatus 100, e.g., during relatively hot conditions. The air mover or fan can be deactivated, e.g., during relatively cold conditions.

In some examples, as depicted in FIG. 1B, the thermal control apparatus 100 can include a heatsink thermal pad 156 and a top plate 158. The heatsink thermal pad 156 can be formed of a TIM and can be disposed on the top ends of the fins 132. The top plate 158 can be disposed on the heatsink thermal pad 156. In such examples, heat can be transferred from the fins 132 to the heatsink thermal pad 156 and then to the top plate 158. The top plate 158, which can be formed of a thermally conductive material, can then carry the heat further away from the IC 104, such as to a remote heatsink 160 represented schematically in FIG. 1B. The remote heatsink 160 can be, for example, a chassis or casing of a computing system, another heatsink having fins, or some other component.

Accordingly, the thermal control apparatus 100 provides a dual-purpose thermal solution in the form of a heatsink with an integrated smart heater, which allows the electronic component, or IC 104, to be cooled using the heatsink in high temperature environments and the smart heater can be controlled to heat the electronic component above its minimum working temperature limit in cold temperature environments. In this regard, the thermal control apparatus 100 can facilitate meeting qualification and performance requirements.

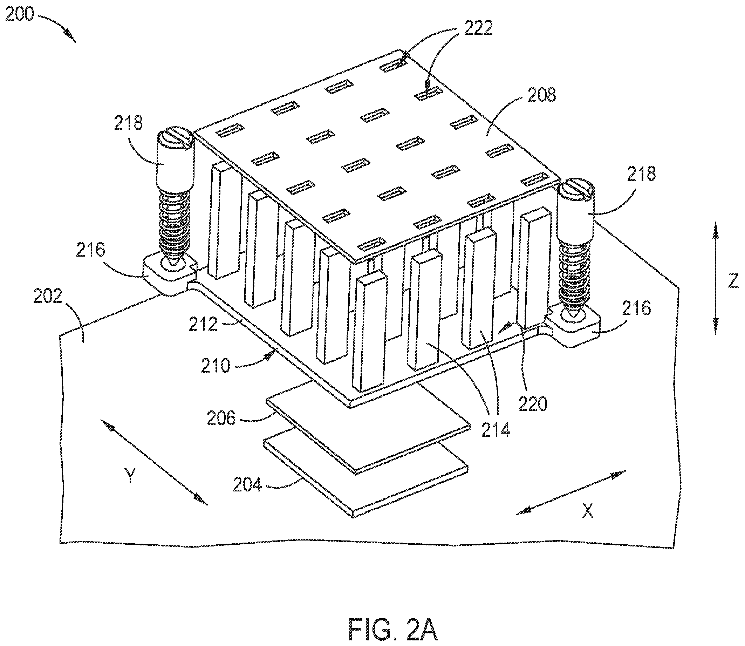

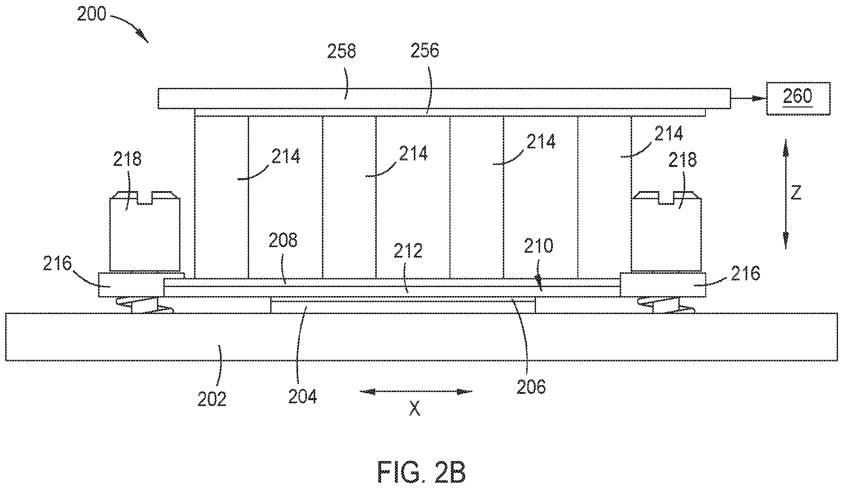

FIGS. 2A and 2B illustrate a thermal control apparatus 200. For reference, the thermal control apparatus 200 can define a first direction X, a second direction Y, and a third direction Z, which are mutually perpendicular to one another.

As depicted in FIGS. 2A and 2B, the thermal control apparatus 200 can include a PCB 202 and an electronic component disposed on the PCB 202. For instance, the electronic component can be an IC 204. The IC 204 can be, for example, an ASIC, a memory device, etc. The thermal control apparatus 200 can also include a thermal pad 206 disposed on the IC 204. The thermal pad 206 can be formed of a TIM. In some examples, the thermal pad 206 can be disposed directly on the IC 204, e.g., as shown in FIGS. 2A and 2B. In at least some examples, an area of the thermal pad 206 can be equal to an area of the IC 204. In some other examples, the area of the thermal pad 206 can be different than the area of the IC 204.

The thermal control apparatus 200 can further include a thin film smart heater, or heater film 208. The heater film 208 can be arranged in thermal communication with the IC 204 so that the heater film 208 can heat the IC 204, e.g., in relatively cold conditions. In at least some examples, the heater film 208 can be a thin film polyamide heater and can include circuitry that can be selectively activated to heat the IC 204, e.g., in relatively cold conditions. The heater film 208 can be a COTS smart heater or a custom heater implemented with one or more sensing elements as part of a heater control system.

The thermal control apparatus 200 can also include a heatsink 210. The heatsink 210 is arranged in thermal communication with the IC 204 for dissipating heat generated by the IC 204, e.g., during relatively hot conditions. The heatsink 210 has a base 212 and a plurality of pillars 214 extending from the base 212. The heatsink 210 can be stacked on the thermal pad 206 and the IC 204. In some examples, a bottom surface of the base 212 can contact a top surface of the thermal pad 206. Mounting posts 216 can project from corners of the base 212, such as from opposing corners as shown in FIGS. 2A and 2B. Captive screws 218 can be inserted through the mounting posts 216 to secure the heatsink 210 to the PCB 202. The pillars 214 extend from a top surface 220 of the base 212, e.g., along the third direction Z. The pillars 214 have rectangular cross sections, as viewed along the third direction Z, but can have other cross-sectional shapes in some other examples. The pillars 214 are arranged in rows and columns in an XY array, with twenty (20) pillars total. However, the heatsink 210 can have more or less than twenty (20) pillars in other examples and other arrangements of the pillars 214 are contemplated. In some examples, the pillars 214 can be hollow with wick structures embedded therein.

The heater film 208 defines a plurality of apertures 222. The apertures 222 are shaped complementary to, and are sized to receive, the pillars 214. In this way, the apertures 222 can be aligned with the pillars 214 and the heater film 208 can be slid downward along the third direction Z so that the heater film 208 is arranged on, or in contact with, the top surface 220 of the base 212, e.g., as shown in FIG. 2B. Accordingly, when the thermal control apparatus 200 is assembled, the IC 204 is disposed on the PCB 202, the thermal pad 206 is disposed on the IC 204, the base 212 of the heatsink 210 is disposed on the thermal pad 206, and the heater film 208 is disposed on the base 212 of the heatsink 210.

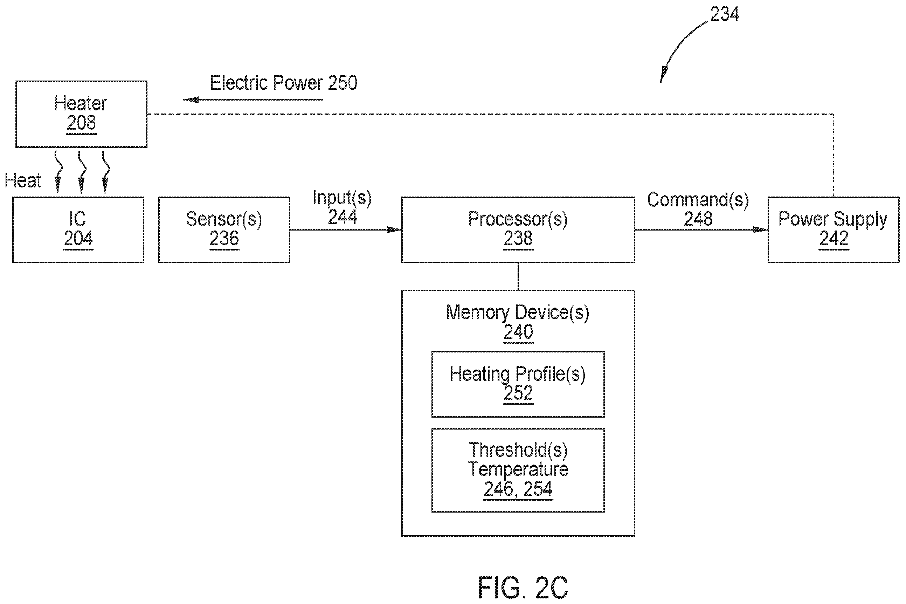

FIG. 2C depicts one example heater control system 234 for controlling the heater film 208, e.g., during relatively cold conditions. The heater control system 234 can include a sensor 236 (or a plurality of sensors), a processor 238 (or a plurality of processors), a memory device 240 (e.g., or a plurality of non-transitory memory devices), a power supply 242, and the heater film 208. In some examples, the processor 238 and the memory device 240 can be embodied in a computing device or controller. The computing device can have a communication interface for facilitating communication between the computing device and other devices, such as the sensor 236, the power supply 242, etc. The sensor 236 is communicatively coupled with the processor 238, e.g., by way of one or more wired or wireless communication links. The sensor 236 can be arranged to sense a temperature of the IC 204. The sensor 236 can be attached to, integrated into, or placed in proximity to the IC 204 so that the temperature of the IC 204 can be sensed. The processor 238 can receive inputs 244 from the sensor 236 indicating a temperature of the IC 204.

The processor 238 can receive the inputs 244, and based on the inputs 244, the processor 238 can determine the temperature of the IC 204. Based on the temperature of the IC 204, the heater film 208 can be selectively activated. For instance, during relatively cold conditions, such as during conditions in which the temperature of the IC 204 is at or below zero degrees Celsius (0°C), the processor 238 can control the power supply 242 electrically coupled with the heater film 208 to supply electric power to the heater film 208. In at least some examples, when the temperature associated with the IC 204 reaches an activation threshold temperature 246 (e.g., zero degrees Celsius (0°C)), the processor 238 can send a command 248 (or a plurality of commands) to the power supply 242. In this regard, the processor 238 is communicatively coupled with the power supply 242, e.g., by way of one or more wired or wireless communication links. Based on the command 248, controllable devices (e.g., switches) of the power supply 242 can be controlled so that electric power 250 is directed to the heater film 208. The electric power 250 delivered to the heater film 208 can cause the heater film 208 to generate heat, e.g., by electric current passing through electric resistive elements (e.g., resistors) of the heater film 208. Accordingly, when the heater film 208 is selectively activated (e.g., in relatively cold conditions), a conductive thermal path can be defined between the heater film 208 and the IC 204, with the thermal path extending through the base 212 and the thermal pad 206. Thus, heat generated by the heater film 208 can travel from the heater film 208 to the base 212, from the base 212 to the thermal pad 206, and from the thermal pad 206 to the IC 204. In this way, the heater film 208 can heat the IC 204 during relatively cold conditions.

In some examples, the heater film 208 can be heated according to a heating profile 252 based on the temperature at the IC 204. The memory device 240, which is communicatively coupled with the processor 238, can store the heating profile 252 (or a plurality of heating profiles). The processor 238 can access the heating profile 252, and based at least in part on the temperature associated with the IC 204, the processor 238 can control the power supply 242 so that the electric power 250 supplied to the heater film 208 is supplied according to the heating profile 252. In some instances, the electric power 250 supplied to the heater film 208 can be varied according to the heating profile 252. In some examples, the electric power 250 supplied to the heater film 208 can be supplied at a rated power until the temperature of the IC 204 is within a predetermined range of a deactivation threshold temperature 254, and when the temperature of the IC 204 is within the predetermined range of the deactivation threshold temperature 254, the electric power 250 supplied to the heater film 208 can be changed (e.g., ramped up or ramped down) based on the temperature of the IC 204 in accordance with the heating profile 252. Controlling the heat output of the heater film 208 according to the heating profile 252 can be beneficial, such as for power consumption purposes.

In at least some examples, when the temperature of the IC 204 reaches the deactivation threshold temperature 254, the heater film 208 can be selectively deactivated so that the IC 204 is no longer heated by the heater film 208. In some examples, the activation threshold temperature 246 can be the same as the deactivation threshold temperature 254. In some other examples, the activation threshold temperature 246 can be different than the deactivation threshold temperature 254. In some other examples, the heater film 208 can be selectively activated, and after a predefined heating time has elapsed, the heater film 208 can be selectively deactivated.

With reference to FIG. 2B, for relatively hot conditions, such as during conditions in which the temperature of the IC 204 is above zero degrees Celsius (0°C), heat can be transferred from the IC 204 to the heatsink 210 along a thermal path. Specifically, when the heater film 208 is selectively deactivated or not active (e.g., during relatively hot conditions), heat generated by the IC 204 can travel from the IC 204 to the thermal pad 206, from the thermal pad 206 to the base 212 of the heatsink 210, and from the base 212 of the heatsink 210 to the heater film 208 and to the pillars 214. The heat can travel vertically upward through the pillars 214, which can be formed of copper or another thermally conductive material. Accordingly, heat can be transferred from the IC 204 to the heatsink 210. In some examples, an air mover or fan (not pictured) can be used to move air across the thermal control apparatus 200, e.g., during relatively hot conditions. The air mover or fan can be deactivated, e.g., during relatively cold conditions.

In some examples, as depicted in FIG. 2B, the thermal control apparatus 200 can include a heatsink thermal pad 256 and a top plate 258. The heatsink thermal pad 256 can be formed of a TIM and can be disposed on the top ends of the pillars 214. The top plate 258 can be disposed on the heatsink thermal pad 256. In such examples, heat can be transferred from the pillars 214 to the heatsink thermal pad 256 and then to the top plate 258. The top plate 258, which can be formed of a thermally conductive material, can then carry the heat further away from the IC 204, such as to a remote heatsink 260 represented schematically in FIG. 2B. The remote heatsink 260 can be, for example, a chassis or casing of a computing system, another heatsink, or some other component.

Accordingly, the thermal control apparatus 200 provides a dual-purpose thermal solution in the form of a heatsink with an integrated smart heater, which allows the electronic component, or IC 204, to be cooled using the heatsink in high temperature environments and the smart heater can be controlled to heat the electronic component above its minimum working temperature limit in cold temperature environments. In this regard, the thermal control apparatus 200 can facilitate meeting qualification and performance requirements.

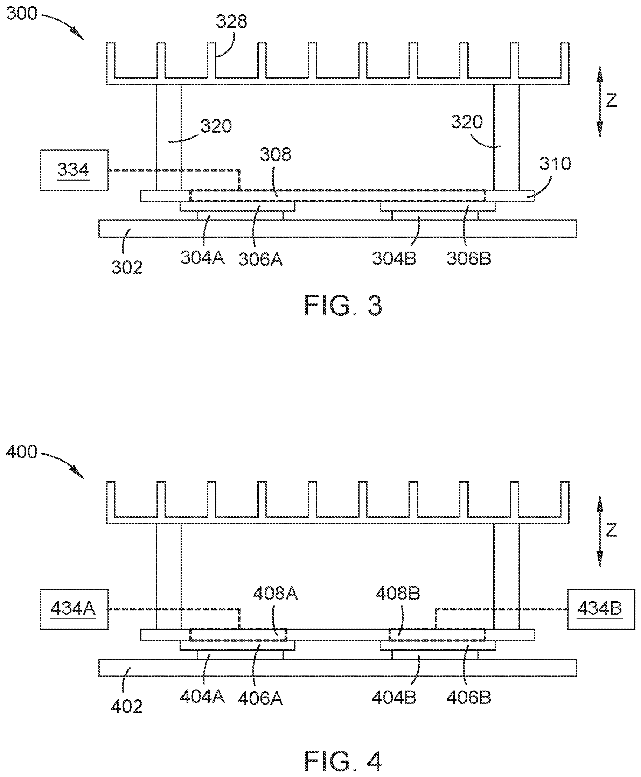

FIG. 3 illustrates a thermal control apparatus 300. The thermal control apparatus 300 of FIG. 3A is arranged as a Multi-Chip Module (MCM). Accordingly, the thermal control apparatus 300 can include a PCB 302 and at least first and second electronic components disposed thereon. The first and second electronic components can be a first IC 304A and a second IC 304B. First and second thermal pads 306A, 306B can be disposed on the first and second ICs 304A, 304B, respectively. In some examples, such as in the example of FIG. 3, the thermal control apparatus 300 can include a thin film smart heater, or heater film 308, that functions to heat both the first and second ICs 304A, 304B, e.g., during relatively cold conditions. The heater film 308 can be directly disposed on the first and second thermal pads 306A, 306B, e.g., as shown in FIG. 3. The heater film 308 can be disposed within a cutout defined by a frame 310. Heat columns 320 can extend from the frame 310. A heatsink 328 can be disposed on the heat columns 320. In some other examples, the heater film 308 can be disposed on a top surface of a base of a heatsink, e.g., similar to the example of FIGS. 2A, 2B in which the heater film 208 is disposed on the base 212 of the heatsink 210. The heater film 308 can have a corresponding heater control system 334, which can include similar components and can function in a similar manner as the heater control systems 134, 234 described previously.

The heater film 308 of the thermal control apparatus 300 can thus heat multiple chips, or ICs 304A, 304B. In some examples, the heater control system 334 can include temperature sensors at or proximate each one of the ICs 304A, 304B. When the temperature at one of the ICs 304A, 304B is sensed to be at or below a temperature activation threshold temperature, the heater film 308 can be activated. In some examples, the heater film 308 can be activated when an average temperature at the ICs 304A, 304B is at or below an activation threshold temperature. In some other examples, the heater film 308 can be activated only when the temperature at both the ICs 304A, 304B is at or below an activation threshold temperature. In some further examples, the heater control system 334 can include a single temperature sensor at or proximate one of the ICs 304A, 304B (e.g., within sensing range), and when the temperature at the IC is sensed to be at or below a temperature activation threshold temperature, the heater film 308 can be activated. The heater film 308 can be deactivated when the temperature at one, both, or an average thereof reaches a deactivation threshold temperature.

In some examples, an air mover or fan (not pictured) can be used to move air across the thermal control apparatus 300, e.g., during relatively hot conditions. The air mover or fan can be deactivated, e.g., during relatively cold conditions.

FIG. 4 illustrates a thermal control apparatus 400. The thermal control apparatus 400 of FIG. 4 is arranged as an MCM. Accordingly, the thermal control apparatus 400 can include a PCB 402 and at least first and second electronic components disposed thereon. The first and second electronic components can be a first IC 404A and a second IC 404B. First and second thermal pads 406A, 406B can be disposed on the first and second ICs 404A, 404B, respectively. In some examples, such as in the example of FIG. 4, the thermal control apparatus 400 can include at least two thin film smart heaters, including a first heater film 408A and a second heater film 408B. The first and second heaters 408A, 408B can be arranged and can function to heat the first and second ICs 404A, 404B, respectively, e.g., during relatively cold conditions. The first and second heaters 408A, 408B can be directly disposed on the first and second thermal pads 406A, 406B, e.g., as shown in FIG. 4, or can be disposed on a top surface of a base of a heatsink, e.g., similar to the example of FIGS. 2A, 2B. The first and second heaters 408A, 408B can each have a heater control system. For instance, the first heater film 408A can have a first heater control system 434A and the second heater film 408B can have a second heater control system 434B. The first and second heater control systems 434A, 434B can each include similar components and can function in a similar manner as the heater control systems 134, 234 described previously. Advantageously, having heaters for respective ones of the electronic components of the thermal control apparatus 400 can allow for the heaters to heat their respective electronic components according to heating profiles specific to the electronic components.

In some examples, the heater control systems 434A, 434B for controlling the first and second heaters 408A, 408B can share at least one component, such as a processor, memory device, and/or power supply. In this way, the number of components of the thermal control apparatus 400 can be reduced.

In some examples, an air mover or fan (not pictured) can be used to move air across the thermal control apparatus 400, e.g., during relatively hot conditions. The air mover or fan can be deactivated, e.g., during relatively cold conditions.

In the current disclosure, reference is made to various examples. However, it should be understood that the present disclosure is not limited to specific described examples. Instead, any combination of the following features and elements, whether related to different aspects or not, is contemplated to implement and practice the teachings provided herein. Additionally, when elements of the examples are described in the form of "at least one of A and B," it will be understood that aspects including element A exclusively, including element B exclusively, and including element A and B are each contemplated. Furthermore, although some examples may achieve advantages over other possible solutions and/or over the prior art, whether or not a particular advantage is achieved by a given example is not limiting of the present disclosure. Thus, the examples, features and advantages disclosed herein are merely illustrative and are not considered elements or limitations of the appended claims except where explicitly recited in a claim(s).

As will be appreciated by one skilled in the art, examples described herein may be embodied as a system, method or computer program product. Accordingly, examples may take the form of an entirely hardware example, an entirely software example (including firmware, resident software, micro-code, etc.) or an example combining software and hardware examples that may all generally be referred to herein as a "circuit," "module" or "system." Furthermore, examples described herein may take the form of a computer program product embodied in one or more computer readable storage medium(s) having computer readable program code embodied thereon.

Program code embodied on a computer readable storage medium may be transmitted using any appropriate medium, including but not limited to wireless, wireline, optical fiber cable, RF, etc., or any suitable combination of the foregoing.

Computer program code for carrying out operations for examples of the present disclosure may be written in any combination of one or more programming languages, including an object oriented programming language such as Java, Smalltalk, C++ or the like and conventional procedural programming languages, such as the "C" programming language or similar programming languages. The program code may execute entirely on the user's computer, partly on the user's computer, as a stand-alone software package, partly on the user's computer and partly on a remote computer or entirely on the remote computer or server. In the latter scenario, the remote computer may be connected to the user's computer through any type of network, including a local area network (LAN) or a wide area network (WAN), or the connection may be made to an external computer (for example, through the Internet using an Internet Service Provider).

Examples of the present disclosure are described herein with reference to flowchart illustrations and/or block diagrams of methods, apparatuses (systems), and computer program products according to examples of the present disclosure. It will be understood that each block of the flowchart illustrations and/or block diagrams, and combinations of blocks in the flowchart illustrations and/or block diagrams, can be implemented by computer program instructions. These computer program instructions may be provided to a processor of a general purpose computer, special purpose computer, or other programmable data processing apparatus to produce a machine, such that the instructions, which execute via the processor of the computer or other programmable data processing apparatus, create means for implementing the functions/acts specified in the block(s) of the flowchart illustrations and/or block diagrams.

These computer program instructions may also be stored in a computer readable medium that can direct a computer, other programmable data processing apparatus, or other device to function in a particular manner, such that the instructions stored in the computer readable medium produce an article of manufacture including instructions which implement the function/act specified in the block(s) of the flowchart illustrations and/or block diagrams.

The computer program instructions may also be loaded onto a computer, other programmable data processing apparatus, or other device to cause a series of operational steps to be performed on the computer, other programmable apparatus or other device to produce a computer implemented process such that the instructions which execute on the computer, other programmable data processing apparatus, or other device provide processes for implementing the functions/acts specified in the block(s) of the flowchart illustrations and/or block diagrams.

The flowchart illustrations and block diagrams in the Figures illustrate the architecture, functionality, and operation of possible implementations of systems, methods, and computer program products according to various examples of the present disclosure. In this regard, each block in the flowchart illustrations or block diagrams may represent a module, segment, or portion of code, which comprises one or more executable instructions for implementing the specified logical function(s). It should also be noted that, in some alternative implementations, the functions noted in the block may occur out of the order noted in the Figures. For example, two blocks shown in succession may, in fact, be executed substantially concurrently, or the blocks may sometimes be executed in the reverse order or out of order, depending upon the functionality involved. It will also be noted that each block of the block diagrams and/or flowchart illustrations, and combinations of blocks in the block diagrams and/or flowchart illustrations, can be implemented by special purpose hardware-based systems that perform the specified functions or acts, or combinations of special purpose hardware and computer instructions.

While the foregoing is directed to examples of the present disclosure, other and further examples of the disclosure may be devised without departing from the basic scope thereof, and the scope thereof is determined by the claims that follow.

The following clauses present further examples:
Clause 1. A thermal control apparatus (100, 200), comprising:
   an integrated circuit (IC) (104, 204);
   a heater film (108, 208) arranged in thermal communication with the IC (104, 204), the heater film (108, 208) being arranged to selectively heat the IC (104, 204) when a temperature associated with the IC (104, 204) reaches a threshold (146, 246); and
   a heatsink (128, 210) arranged in thermal communication with the IC (104, 204) for dissipating heat generated by the IC (104, 204).
Clause 2. The thermal control apparatus (100, 200) of Clause 1, further comprising:
   a thermal pad (106, 206) disposed between the IC (104, 204) and the heater film (108, 208), wherein the heater film (108, 208) is disposed directly on the thermal pad (106, 206).
Clause 3. The thermal control apparatus (100, 200) of Clause 1 or Clause 2, further comprising:
   a frame (110) defining a cutout (118) in which the heater film (108) is disposed.
Clause 4. The thermal control apparatus (100, 200) of Clause 3, further comprising:
   a plurality of heat columns (120) attached to the frame (110) at their respective first ends (122) and to a base (130) of the heatsink (128) at their respective second ends (124).
Clause 5. The thermal control apparatus (100, 200) of Clause 3 or Clause 4, wherein at least a portion of the thermal pad (106) directly contacts the frame (110).
Clause 6. The thermal control apparatus (100, 200) of any of Clauses 3 - 5, further comprising:
   a printed circuit board (PCB) (102), the IC (104) being disposed on the PCB (102); and
   captive screws (112) coupling the frame (110) with the PCB (102).
Clause 7. The thermal control apparatus (100, 200) of any preceding Clause, further comprising:
   a sensor (136, 236) arranged to sense the temperature associated with the IC (104, 204);
   a power supply (142, 242) electrically coupled with the heater film (108, 208); and
   one or more processors (138, 238) communicatively coupled with the sensor (136, 236) and the power supply (142, 242), the one or more processors (138, 238) being configured to: receive, from the sensor (136, 236), inputs (144, 244) indicating the temperature associated with the IC (104, 204); and
   when the temperature associated with the IC (104, 204) reaches the threshold (146, 246), cause the power supply (142, 242) to supply electric power to the heater film (108, 208).
Clause 8. The thermal control apparatus (100, 200) of Clause 7, wherein the electric power supplied to the heater film (108, 208) varies according to a heating profile (152, 252) based at least in part on the temperature associated with the IC (104, 204).
Clause 9. The thermal control apparatus (100, 200) of any preceding Clause, wherein the heater film (208) is disposed directly on a base (212) of the heatsink (210).
Clause 10. The thermal control apparatus (100, 200) of Clause 9, wherein the heatsink (210) has a plurality of pillars (214) and the heater film (208) defines a plurality of apertures (222) through which the plurality of pillars (214) extend.
Clause 11. The thermal control apparatus (100, 200) of Clause 9 or Clause 10, wherein the base (212) of the heatsink (128, 210) has mounting posts (216) through which respective captive screws (218) extend through and couple the heatsink (128, 210) with a printed circuit board (202).
Clause 12. The thermal control apparatus (100, 200) of any preceding Clause, further comprising:
   a heatsink thermal pad (156, 256) arranged on the heatsink (128, 210); and
   a top plate (158, 258) disposed on the heatsink thermal pad (156, 256), the top plate (158, 258) being in thermal communication with a remote heatsink (160, 260).
Clause 13. The thermal control apparatus (100, 200) of any preceding Clause, further comprising:
   a second IC (304B); and
   a second thermal pad (306B) disposed on the second IC (304B),
   wherein the heater film (108, 208) is arranged in thermal communication with the second IC (304B), the heater film (108, 208) being arranged to selectively heat the IC (104, 204) and the second IC (304B) when a temperature associated with the IC (104, 204), the second IC (304B), or both reaches a threshold, and
   wherein the heatsink (128, 210) is arranged in thermal communication with the second IC (304B) for dissipating heat generated by the second IC (304B).
Clause 14. The thermal control apparatus (100, 200) of any of Clauses 1 - 12, further comprising:
   a second IC (404B);
   a second thermal pad (406B) disposed on the second IC (404B); and
   a second heater film (408B) arranged in thermal communication with the second IC (404B), the second heater film (408B) being arranged to selectively heat the second IC (404B) when a temperature associated with the second IC (404B) reaches a threshold, and
   wherein the heatsink (128, 210) is arranged in thermal communication with the second IC (404B) for dissipating heat generated by the second IC (404B).
Clause 15. A thermal control apparatus (100), comprising:
   a printed circuit board (PCB);
   an integrated circuit (IC) (104);
   a thermal pad (106) disposed on the IC (104);
   a frame (110) securing the IC (104) and the thermal pad (106) to the PCB (102), the frame (110) defines a cutout (118) and has a frame body (114) and heat columns (120) extending from the frame body (114);
   a heater film (108) disposed on the IC (104) and within the cutout (118), the heater film (108) being arranged to selectively heat the IC (104) when a temperature associated with the IC (104) reaches a threshold (146); and
   a heatsink (128) supported by the heat columns (120) and arranged in thermal communication with the IC (104) for dissipating heat generated by the IC (104).
Clause 16. The thermal control apparatus (100) of Clause 15, further comprising:
   a sensor (136) arranged to sense the temperature associated with the IC (104);
   a power supply (142) electrically coupled with the heater film (108); and
   one or more processors (138) communicatively coupled with the sensor (136) and the power supply (142), the one or more processors (138) being configured to:
      receive, from the sensor (136), inputs (144) indicating the temperature associated with the IC (104); and
      when the temperature associated with the IC (104, 204) reaches the threshold (146), cause the power supply (142) to supply electric power to the heater film (108).
Clause 17. The thermal control apparatus (100) of Clause 16, wherein the one or more processors (138) are further configured to:
   when the temperature associated with the IC (104, 204) reaches a deactivation threshold temperature (154), cause the power supply (142) to cease supplying electric power to the heater film (108).
Clause 18. A thermal control apparatus (200), comprising:
   an integrated circuit (IC) (204);
   a heatsink (210) arranged in thermal communication with the IC (204) for dissipating heat generated by the IC (204) and having a base (212) and a plurality of pillars (214) extending from the base (214); and
   a heater film (208) disposed on the base (214) and defining a plurality of apertures (222) through which the plurality of pillars (214) extend, the heater film (208) being arranged to selectively heat the IC (204) when a temperature associated with the IC (204) reaches a threshold (246).
Clause 19. The thermal control apparatus (200) of Clause 18, further comprising:
   a sensor (236) arranged to sense the temperature associated with the IC (204);
   a power supply (242) electrically coupled with the heater film (208); and
   one or more processors (238) communicatively coupled with the sensor (236) and the power supply (242), the one or more processors (238) being configured to:
      receive, from the sensor (236), inputs (244) indicating the temperature associated with the IC (204); and
      when the temperature associated with the IC (204) reaches the threshold (244), cause the power supply (242) to supply electric power to the heater film (208).
Clause 20. The thermal control apparatus (200) of Clause 19, wherein the one or more processors (238) are further configured to:
   when the temperature associated with the IC (204) reaches a deactivation threshold temperature (254), cause the power supply (242) to cease supplying electric power to the heater film (208).

## Claims

1. A thermal control apparatus (100, 200), comprising:
an integrated circuit, IC, (104, 204);
a heater film (108, 208) arranged in thermal communication with the IC (104, 204), the heater film (108, 208) configured to selectively heat the IC (104, 204) when a temperature associated with the IC (104, 204) reaches a threshold (146, 246); and
a heatsink (128, 210) arranged in thermal communication with the IC (104, 204) and configured to dissipate heat generated by the IC (104, 204).

2. The thermal control apparatus (100, 200) of claim 1, further comprising:
a thermal pad (106, 206) disposed between the IC (104, 204) and the heater film (108, 208), wherein the heater film (108, 208) is disposed directly on the thermal pad (106, 206).

3. The thermal control apparatus (100, 200) of claim 1 or claim 2, further comprising:
a frame (110) defining a cutout (118) in which the heater film (108) is disposed.

4. The thermal control apparatus (100, 200) of claim 3, further comprising:
a plurality of heat columns (120) attached to the frame (110) at their respective first ends (122) and to a base (130) of the heatsink (128) at their respective second ends (124).

5. The thermal control apparatus (100, 200) of claim 3 or claim 4, wherein at least a portion of the thermal pad (106) directly contacts the frame (110).

6. The thermal control apparatus (100, 200) of any of claims 3 - 5, further comprising:
a printed circuit board, PCB, (102), the IC (104) being disposed on the PCB (102); and
captive screws (112) coupling the frame (110) with the PCB (102).

7. The thermal control apparatus (100, 200) of any preceding claim, further comprising:
a sensor (136, 236) configured to sense the temperature associated with the IC (104, 204);
a power supply (142, 242) electrically coupled with the heater film (108, 208); and
one or more processors (138, 238) communicatively coupled with the sensor (136, 236) and the power supply (142, 242), the one or more processors (138, 238) being configured to:
receive, from the sensor (136, 236), inputs (144, 244) indicating the temperature associated with the IC (104, 204);
when the temperature associated with the IC (104, 204) reaches the threshold (146, 246), cause the power supply (142, 242) to supply electric power to the heater film (108, 208); and optionally,
when the temperature associated with the IC (104, 204) reaches a deactivation threshold temperature (154), cause the power supply (142, 242) to cease supplying electric power to the heater film (108, 208), and
wherein the electric power supplied to the heater film (108, 208) varies according to a heating profile (152, 252) based at least in part on the temperature associated with the IC (104, 204).

8. The thermal control apparatus (100, 200) of any preceding claim, wherein the heater film (208) is disposed directly on a base (212) of the heatsink (210).

9. The thermal control apparatus (100, 200) of claim 8, wherein the heatsink (210) has a plurality of pillars (214) and the heater film (208) defines a plurality of apertures (222) through which the plurality of pillars (214) extend, and optionally,
wherein the base (212) of the heatsink (210) has mounting posts (216) through which respective captive screws (218) extend through and couple the heatsink (210) with a printed circuit board (202).

10. The thermal control apparatus (100, 200) of any preceding claim, further comprising:
a heatsink thermal pad (156, 256) arranged on the heatsink (128, 210); and
a top plate (158, 258) disposed on the heatsink thermal pad (156, 256), the top plate (158, 258) configured to be in thermal communication with a remote heatsink (160, 260).

11. The thermal control apparatus (100, 200) of any preceding claim, further comprising:
a second IC (304B); and
a second thermal pad (306B) disposed on the second IC (304B),
wherein the heater film (108, 208) is arranged in thermal communication with the second IC (304B), and wherein the heater film (108, 208) is configured to selectively heat the IC (104, 204) and the second IC (304B) when the temperature associated with the IC (104, 204), the second IC (304B), or both, reaches a threshold, and
wherein the heatsink (128, 210) is arranged in thermal communication with the second IC (304B) and configured to dissipate heat generated by the second IC (304B).

12. The thermal control apparatus (100, 200) of any of claims 1 - 10, further comprising:
a second IC (404B);
a second thermal pad (406B) disposed on the second IC (404B); and
a second heater film (408B) arranged in thermal communication with the second IC (404B), the second heater film (408B) configured to selectively heat the second IC (404B) when a temperature associated with the second IC (404B) reaches a threshold, and
wherein the heatsink (128, 210) is arranged in thermal communication with the second IC (404B) and configured to dissipate heat generated by the second IC (404B).

13. The thermal control apparatus (100) of claim 1, further comprising:
a printed circuit board, PCB,;
a thermal pad (106) disposed on the IC (104); and
a frame (110) securing the IC (104) and the thermal pad (106) to the PCB (102), wherein the frame (110) defines a cutout (118) and has a frame body (114) and heat columns (120) extending from the frame body (114);
wherein the heater film (108) is disposed on the IC (104) and within the cutout (118); and
wherein the heatsink (128) is supported by the heat columns (120).

14. The thermal control apparatus (200) of claim 1, wherein:
the heatsink (210) has a base (212) and a plurality of pillars (214) extending from the base (214); and
the heater film (208) is disposed on the base (212) and defines a plurality of apertures (222) through which the plurality of pillars (214) extend.

15. The thermal control apparatus (100, 200) of claim 13 or claim 14, further comprising:
a sensor (136, 236) arranged to sense the temperature associated with the IC (104, 204);
a power supply (142, 242) electrically coupled with the heater film (108, 208); and
one or more processors (138, 238) communicatively coupled with the sensor (136, 236) and the power supply (142, 242), the one or more processors (138, 238) being configured to:
receive, from the sensor (136, 236), inputs (144, 244) indicating the temperature associated with the IC (104, 204);
when the temperature associated with the IC (104, 204) reaches the threshold (146, 246), cause the power supply (142, 242) to supply electric power to the heater film (108, 208); and optionally,
when the temperature associated with the IC (104, 204) reaches a deactivation threshold temperature (154, 254), cause the power supply (142, 242) to cease supplying electric power to the heater film (108, 208).
